# EUROPEAN PATENT SPECIFICATION

(11) **EP 4 307 351 B1**
(45) Date of publication and mention of the grant of the patent: **06.08.2025**
(21) Application number: 22782811.8
(22) Date of filing: 13.06.2022
(51) Int. Cl.: H01L 21/66, H01L 23/522, H01L 23/538, H01L 23/00

(54) **PACKAGING STRUCTURE, PACKAGING METHOD, AND SEMICONDUCTOR DEVICE**
VERPACKUNGSSTRUKTUR, VERPACKUNGSVERFAHREN UND HALBLEITERBAUELEMENT
STRUCTURE D'ENCAPSULATION, PROCÉDÉ D'ENCAPSULATION ET DISPOSITIF À SEMI-CONDUCTEUR

(30) Priority: 01.06.2022 CN 202210621408
(43) Date of publication of application: 17.01.2024
(73) Proprietor: Changxin Memory Technologies, Inc., Hefei City, Anhui 230000 (CN)
(72) Inventor: TIAN, Kai, Hefei, Anhui 230601 (CN); LI, Hongwen, Hefei, Anhui 230601 (CN); CHEN, Liang, Hefei, Anhui 230601 (CN); JIANG, Wei, Hefei, Anhui 230601 (CN); LI, Mengfan, Hefei, Anhui 230601 (CN)
(74) Representative: Gulde & Partner
(86) International application number: PCT/CN2022/098437
(87) International publication number: WO 2023/231080

(56) References cited:
- CN-A- 110 120 357
- CN-A- 111 244 057
- KR-A- 20170 017 510
- US-A1- 2009 243 118
- US-A1- 2014 061 900
- US-A1- 2017 062 367
- US-A1- 2017 236 802
- US-A1- 2018 130 751
- US-B1- 6 429 532
- US-B1- 6 573 113

## Description

### CROSS-REFERENCE TO RELATED APPLICATION

This application is based on and claims priority to Chinese Patent Application No.202210621408.5, filed on June 01, 2022 and entitled "PACKAGE STRUCTURE, PACKAGING METHOD AND SEMICONDUCTOR DEVICE".

### TECHNICAL FIELD

The disclosure relates to a technical field of semiconductors, particularly to a package structure, a packaging method and a semiconductor device.

### BACKGROUND

With the rapid increase in the popularity rate of electronic equipment and the vigorous development of the electronic equipment market, electronic products are increasingly required to evolve towards miniaturization and thinness while having a high performance, multifunctionality, high reliability and convenience. Such requirements put forward better, lighter, thinner, higher package density, better electrical and thermal properties, higher reliability and higher cost performance requirements for packaging of semiconductor devices.

In order to ensure the performance of a semiconductor device to meet corresponding requirements, it is necessary to prepare ports for testing and executing functional interactions on a package structure.

US 2017/236802A1 discloses a semiconductor device and method of making wafer level chip scale package, a method of making a semiconductor device comprising: providing a semiconductor wafer; forming a redistribution layer including an interconnect site over the semiconductor wafer; forming a first insulating layer over the redistribution layer with an opening in the first insulating layer over the interconnect site; and forming an interconnect structure within the opening to cover a top surface of the redistribution layer and a side surface of the redistribution layer. US2017/236802A1 is silent on after completing a first type test, removing part of the first pad to form a fourth pad, wherein an area of the fourth pad is smaller than an area of the first pad, i.e. silent on a pad with an area less than a cross-sectional area of the via hole.

US2017/062367A1 discloses a semiconductor chip, semiconductor package including the same, and method of fabricating the same, A semiconductor chip comprising: an integrated circuit on a substrate; a center pad on the substrate and electrically connected to the integrated circuit; a lower insulating structure on the center pad, the lower insulating structure having a contact hole exposing the center pad therethrough, the lower insulating structure including a plurality of lower insulating layers sequentially stacked on the substrate; a conductive pattern including a contact portion, a pad portion, and a conductive line portion, the contact portion filling the contact hole, the pad portion including a test region and a bonding region, the conductive line portion on the lower insulating structure and connecting the contact portion to the pad portion; and an upper insulating structure on the conductive pattern, the upper insulating structure having a first opening exposing the pad portion, the upper insulating structure including an upper insulating layer and a polymer layer, the upper including layer covering the lower insulating structure and the conductive pattern, the polymer layer on the upper insulating layer.

US2014/061900A1 discloses a semiconductor package with improved redistribution layer design and fabricating method thereof, A semiconductor package comprising: a semiconductor die comprising a plurality of bond pads; a first redistribution layer (RDL) formed on the semiconductor die, the first RDL having a first end coupled to a bond pad and a second end coupled to a solder bump via one or more under bump metal layers; and a second RDL formed in a same plane of the semiconductor die as at least a portion of the first RDL, the second RDL being electrically isolated from the first RDL, wherein a first end of the second RDL is coupled to at least one of said plurality of bond pads, and the second RDL passes underneath, but is electrically isolated from, the solder bump coupled to the second end of the first RDL.

US2018/130751A1 discloses a Interconnection structures and methods for transfer-printed integrated circuit elements with improved interconnection alignment tolerance, an electronic component array, comprising: a backplane substrate; a plurality of integrated circuit elements disposed on the backplane substrate, each of the integrated circuit elements comprising a chiplet substrate, a connection pad, and a conductor element disposed on a surface of the chiplet substrate, wherein the connection pad and the conductor element are electrically separated by an insulating layer that exposes at least a portion of the connection pad, and wherein at least one of the integrated circuit elements is misaligned on the backplane substrate relative to a desired position thereon at a distance from the desired position that is greater than or equal to a distance between the conductor element and the connection pad; and a plurality of conductive wires on the backplane substrate, wherein the connection pad of each of the plurality of integrated circuit elements is electrically connected to a respective one of the conductive wires notwithstanding that the at least one of the integrated circuit elements is misaligned on the backplane substrate.

US6573113B1 discloses a Integrated circuit having dedicated probe pads for use in testing densely patterned bonding pads, 1. an integrated circuit topography, comprising a first row and a second row of bonding pads spaced from each other across the topography, wherein every other bonding pad within the first row is connected to every other probe pad within a third row, and wherein every other bonding pad within the second row is connected to every probe pad within a fourth row.

### SUMMARY

The invention is set out in the appended claims 1-8.

### BRIEF DESCRIPTION OF THE DRAWINGS

FIG. 1 is a schematic flowchart of a method for manufacturing a package structure provided by an example of the present disclosure, the example is not in accordance with the claimed invention and is present for illustration purpose only;
FIG. 2A to FIG. 2G are cross-sectional schematic diagrams during a manufacturing process of an package structure provided by an embodiment of the disclosure as far as referring to a fourth pad;
FIG. 3A to FIG. 3C are cross-sectional schematic diagrams during a manufacturing process of a conductive pillar provided by an example of the present disclosure, the example is not in accordance with the claimed invention and is present for illustration purpose only;
FIG. 4A to FIG. 4D are cross-sectional schematic diagrams during a manufacturing process of another package structure provided by an embodiment of the disclosure; and
FIG. 5 is a schematic top view of a layout structure of a semiconductor device provided in an embodiment of the disclosure.

### List of reference numerals:

20, semiconductor functional structure; 201, semiconductor functional layer; 202, interconnecting layer; 301, isolation layer; 302, via hole; 303, first pad; 304, fourth pad; 305, redistribution layer; 306, first insulating layer; 307, second pad; 308, third pad; 309, groove; 310, second insulating layer; 311, conductive pillar; 312, third insulating layer; 501, semiconductor functional structure layout layer; 502, package structure layout layer; 5021, first type pad region; 5021a, partial interconnecting layer region; 5021b, first pad region; 5022, conductive pillar region; 5023, second type pad region; 5023a, redistribution layer region; 5023b, second pad region; and 5023c, third pad region.

In the above drawings (which are not necessarily drawn to scale), similar reference numerals may describe similar parts in different views. Similar reference numerals with different letter suffixes may represent similar parts in different examples. The various embodiments discussed herein are generally shown in the accompanying drawings by way of example.

### DETAILED DESCRIPTION

The technical solutions of the disclosure will be further described in detail below with reference to the drawings and embodiments. While exemplary implementing modes of the disclosure are shown in the drawings it should be understood that the disclosure may be implemented in various forms and should not be limited by the embodiments set forth herein, and only be limited by the claims. In contrast, these embodiments are provided to enable a more thorough understanding of the disclosure and to fully convey the scope of the disclosure to a person skilled in the art.

The embodiments of the disclosure are described in more detail by way of example in the following paragraphs with reference to the drawings. The advantages and features of the disclosure will become clearer according to the following descriptions and claims. It should be noted that the accompanying drawings are all in very simplified forms and in inaccurate scales, and are only used to facilitate and clearly assist the purpose of explaining the embodiments of the disclosure.

It is understood that the meanings of "on", "above" and "over" of the disclosure should be interpreted in the widest manner so that "on" not only means that it is "on" something without an intervening feature or layer being in between (i.e. directly on something), but also includes that it is "above" something with an intervening feature or layer being in between.

In the embodiments of the disclosure, the term "A is connected to B" includes the situation that A and B are in direct contact, and the situation that A and B are indirectly in contact through an intermediate conductive structure.

In the embodiments of the disclosure, the terms "first "and "second", etc. are used to distinguish similar objects and are not necessarily used to describe a specific order or sequence.

In the embodiments of the disclosure, the term "layer" refers to part of material that includes a region having a thickness. A layer may extend over a surface of a lower or upper structure, or may have an area smaller than an extent of the lower or upper structure. Furthermore, a layer may be a region of a homogeneous or heterogeneous continuous structure, having a thickness less than the thickness of the continuous structure. For example, a layer may be between a top surface and the bottom surface of a continuous structure, or the layer may be between any horizontal planes at the top and bottom surfaces of a continuous structure. A layer may extend horizontally, vertically and/or along an inclined surface. A layer may include multiple sub-layers. For example, an interconnection layer may include one or more conductors and contact sub-layers (in which interconnecting wires and/or via hole contacts are formed), and one or more dielectric sub-layers.

It should be noted that technical solutions described in the embodiments of the disclosure can be arbitrarily combined as long as there is no conflict.

A semiconductor functional structure described in the embodiments of the disclosure is used for subsequent processes and forms part of a final semiconductor device, and is a core part to realize a main function of the semiconductor device. Here, the final semiconductor device may include, but is not limited to a memory.

In a design of a packaging structure of a semiconductor device, such as a dynamic random access memory (DRAM), a pad (also called bonding pad) can be disposed in two manners: one is top metal layer windowing, and the other is redistribution layer (RDL) windowing.

The top metal layer windowing refers to that a passivation layer or an insulating layer is formed on a top metal layer of the semiconductor functional structure to protect the semiconductor functional structure from being damaged, and then a windowing region is formed in the passivation layer or the insulating layer to expose part of the top metal layer and thus form the pad. A prode card sticking test may be carried out on the pad to realize an electrical property test of the semiconductor functional structure, and a bonding wire may be leaded out from the pad to realize an electrical leading out of the semiconductor functional structure.

The redistribution layer windowing refers to that a redistribution layer is formed on a top metal layer of the semiconductor functional structure, and a passivation layer or an insulating layer is formed on the redistribution layer, and then a windowing region is formed in the passivation layer or the insulating layer to expose part of the redistribution layer and thus form two pads arranged side by side. One of the two pads is used for performing a probe card sticking test, and the other pad is used for leading out a bonding wire therefrom. Here, the redistribution layer can play a role of adjusting a position of a pad in a semiconductor device, and can also play a role of enhancing a power supplying network of a power ground.

Understandably, the top metal layer is relatively thin, and there is a gasket structure below it, which can support the probe card sticking test first, and then the bonding wire packaging in a packaging factory on the same windowing metal region without affecting the yield of packaging and wiring. The material of the redistribution layer is generally a metal, and the redistribution layer is thicker than the top metal layer, and thus there are usually deep and rough sticking traces on the surface after the probe card sticking test. Such sticking traces may affect the yield of packaging and wiring. Therefore, in the redistribution layer, the pad used for testing and the pad used for leading out bonding wires are different. No matter which of the above windowing manners is adopted in a package structure, it has little influence on the function of a semiconductor device. The redistribution layer windowing is beneficial to improving the performance, but it increases the production cycle and production cost.

In the related art, one of the above two windowing manners is generally selected to design a package structure according to an actual requirement of a semiconductor device. However, in practical applications, in a production process of semiconductor devices, the requirement is no single, and there are often multiple requirements. Here are several examples of such multiple requirements.

Exemplarily, before a mass production of a semiconductor device (or referred to as "product"), there is a long term of the functional debugging process. In the debugging process, a test is completed with a low running speed of a semiconductor functional structure. In this situation, only the top metal windowing is needed to be adopted to complete the packaging and the testing of the semiconductor functional structure. However, when the manufacturing process of the product is mature and it is necessary to test the semiconductor functional structure under a state of running at a high speed, the redistribution layer windowing is needed to be adopted for a packaging test.

Exemplarily, when a semiconductor functional structure itself has different functional demands, a test for the same semiconductor functional structure can be classified into a standard grade test and an advanced grade test according to different demands. The requirements for windowing modes of the different test grades of the semiconductor functional structure are also different. When the standard grade test is performed on the semiconductor functional structure, the top metal layer windowing can be adopted for the packaging and testing, and the role of a redistribution layer is not apparent. When the advanced grade test is performed on the semiconductor functional structure, the redistribution layer windowing is needed to be adopted for the packaging and testing, to improve the performance of the product.

To sum up, in the related art, adopts one of the two windowing manners in a package structure of a semiconductor functional structure cannot meet different test demands to the semiconductor functional structure of a semiconductor device during different manufacturing process stages. In view of this, in order to solve at least one of the above problems, the embodiments of disclosure provides a package structure, a packaging method and a semiconductor device, which are compatible with the two types of tests, meet the requirements that a semiconductor functional structure can be subjected to different types of tests in different manufacturing process stages, improve flexibility of testing, shorten the production cycle and reduce manufacturing cost.

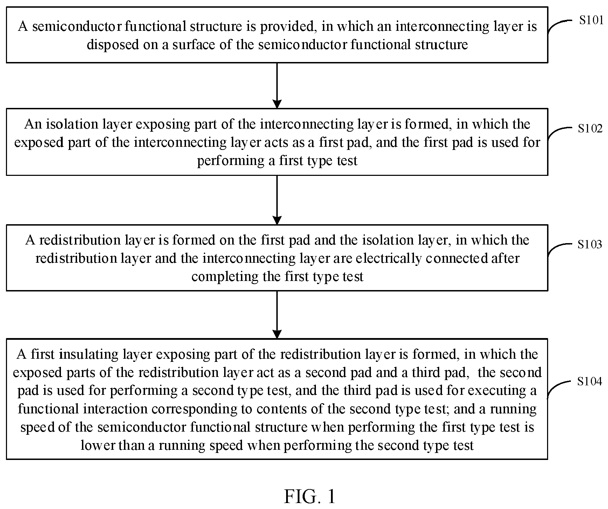

FIG. 1 is a schematic flowchart of a method for manufacturing a package structure provided by an example of the present disclosure, the example is not in accordance with the claimed invention and is present for illustration purpose only. As shown in FIG. 1, a method for manufacturing a package structure includes the following operations.

At S101, a semiconductor functional structure is provided, in which an interconnecting layer is disposed on a surface of the semiconductor functional structure.

At S102, an isolation layer exposing part of the interconnecting layer is formed, in which the exposed part of the interconnecting layer acts as a first pad, and the first pad is used for performing a first type test.

At S103, after completing the first type test, a redistribution layer is formed on the first pad and the isolation layer, in which the redistribution layer and the interconnecting layer are electrically connected.

At S104, a first insulating layer exposing parts of the redistribution layer is formed, in which the exposed parts of the redistribution layer act as a second pad and a third pad, respectively, the second pad is used for performing a second type test, and the third pad is used for executing a functional interaction corresponding to contents of the second type test; and a running speed of the semiconductor functional structure when performing the first type test is lower than a running speed when performing the second type test.

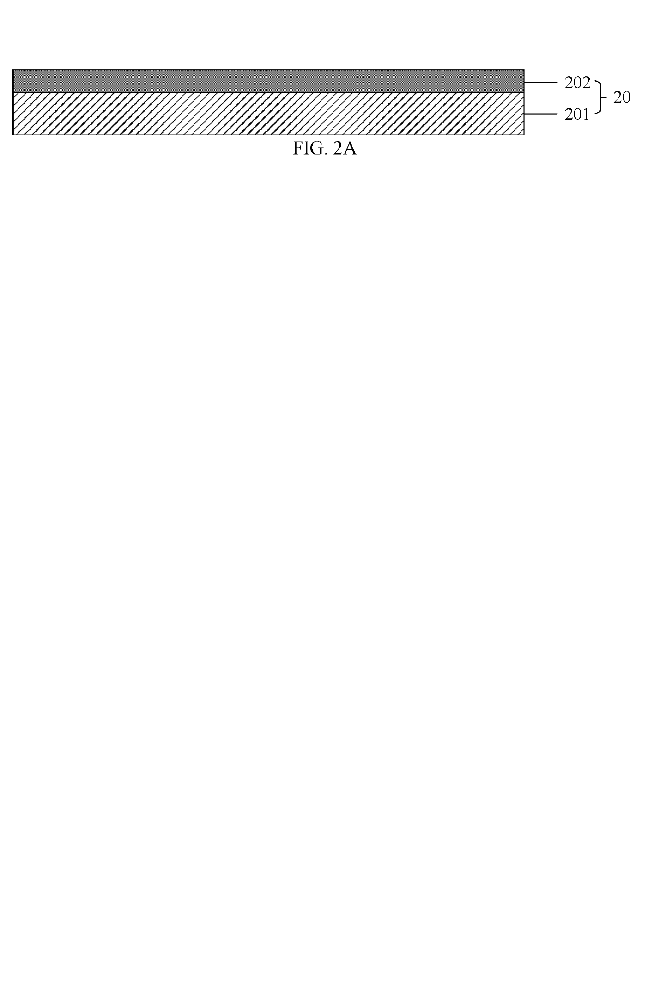

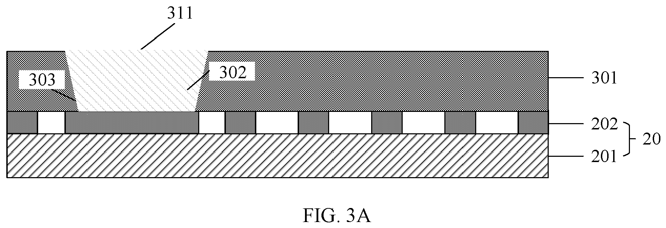

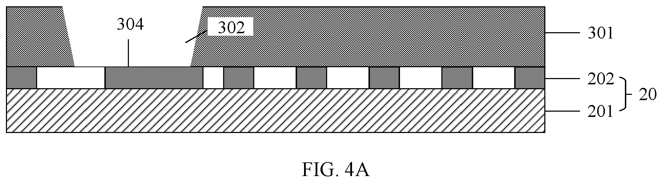

It should be understood that the operations shown in FIG. 1 are not exclusive and that other operations may be performed before, after, or between any of the operations; and the order of the operations shown in FIG. 1 can be adjusted according to actual requirements. FIG. 2A to FIG. 2G are cross-sectional diagrams of structures during a manufacturing process of an package structure provided by an embodiment of the disclosure; FIG. 3A to FIG. 3C are cross-sectional diagrams of structures during a manufacturing process of a conductive pillar provided by an example of the present disclosure, the example is not in accordance with the claimed invention and is present for illustration purpose only; and FIG. 4A to FIG. 4C are cross-sectional diagrams of structures during a manufacturing process of another package structure provided by an embodiments of the disclosure. The method for manufacturing an package structure provided will be described in detail below with reference to FIG. 1, FIG. 2A to FIG. 2G, FIG. 3A to FIG. 3C and FIG. 4A to FIG. 4D.

At S101, a semiconductor functional structure 20 is provided.

Referring to FIG. 2A, providing the semiconductor functional structure 20 includes providing a substrate (not shown in FIG. 2A), in which a semiconductor functional layer 201 is provided on the substrate, and an interconnecting layer 202 is provided on the semiconductor functional layer 201.

Here, the material constituting the substrate may include silicon (Si), germanium (Ge), silicon germanium (SiGe) or the like. In other embodiments, the material of the substrate may also include a silicon-on-insulator (SOI) or a germanium-on-insulator (GOI).

The semiconductor functional layer 201 includes a monolayer thin film or multilayer thin films. The semiconductor functional layer 201 has a conductive layer and/or a dielectric layer. According to actual requirements, multiple microstructure layers may be provided in the semiconductor functional layer 201, in which formation methods of the various microstructure layers may be the same or different. Based on this, a process for forming the semiconductor functional layer 201 includes but is not limited to a process of epitaxis, deposition, etching, polishing and grinding, or the like.

The interconnecting layer 202 can be used for electrically connecting electrical signals of the semiconductor functional layer 201 with other interconnecting structures (for example, a conductive pillar, a interconnecting layer, etc.) and may also be used for playing a supporting role. In some embodiments, the interconnecting layer may include a top metal layer. In some specific embodiments, the material of the interconnecting layer includes, but is not limited to copper (Cu).

Here, the interconnecting layer 202 is formed on the semiconductor functional layer 201 by a process of physical vapor deposition (PVD), chemical vapor deposition (CVD), atomic layer deposition (ALD), or the like.

It should be noted that any signal connected by the redistribution layer formed in the subsequent manufacturing process is connected to the interconnecting layer 202, that is, the function of the semiconductor functional structure 20 is guaranteed to be complete even without the redistribution layer.

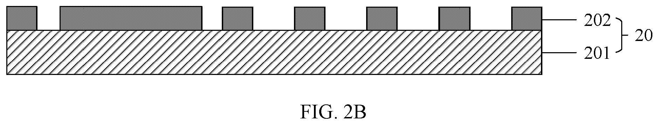

In some embodiments, referring to FIG. 2B, parts of the interconnecting layer 202 are removed before forming the isolation layer 301 to reduce the total area of the interconnecting layer corresponding to the redistribution layer.

Here, the removed parts of the interconnecting layer 202 are the parts that are not physically connected to other interconnecting structures. The process for removing the part of the interconnecting layer 202 includes, but is not limited to an etching process.

Understandably, considering that parasitic capacitance may be introduced with the introduction of the redistribution layer to the large area where the top metal layer is windowed in a subsequent process, reducing the total area of the interconnecting layer is equivalent to reduction of an area of a electrode of the parasitic capacitance formed by the interconnecting layer and the redistribution layer, so that the reduction of the total area of the interconnecting layer 202 is beneficial to reducing additional parasitic capacitance caused by the interconnecting layer 202.

It should be noted that FIG. 2B shows a cross-sectional diagram of a partial section after parts of the interconnecting layer 202 are removed. In practical application, the parts of the interconnecting layer are not separated, but interconnected, that is, from another cross section view, the parts of the interconnecting layer are continuous.

At S102, the first pad for performing a first type test is formed.

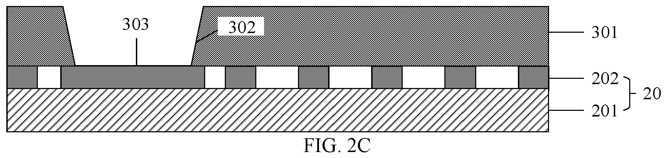

Specifically, referring to FIG. 2C, the isolation layer 301 is formed on the interconnecting layer 202.

Here, the isolation layer 301 is used to protect the interconnecting layer 202 from being damaged. The material of the isolation layer 301 includes, but is not limited to, tetraethyl orthosilicate (TEOS). A process for forming the isolation layer 301 includes, but is not limited to, a process of PVD, CVD, ALD or the like.

In the embodiment of the disclosure, a part region of the isolation layer 301 is removed so that the isolation layer 301 has a plurality of via holes 302. Each via hole 302 exposes part of the interconnecting layer 202, and the exposed part of the interconnecting layer 202 acts as the first pad 303.

Here, the via hole 302 may have a shape of a cylinder or an inverted trapezoid or any suitable shapes. A cross-sectional area of the via hole includes an area of the orthographic projection of the via hole 302 on the plane where the interconnecting layer is located. However, it should be noted that when the via hole 302 has a shape of inverted trapezoid, the cross-sectional area of the first pad 303 is the smallest cross-sectional area of the via hole 302.

In practical application, on the one hand, the first pad 303 is used for performing the first type test; on the other hand, it can be used for executing functional interactions corresponding to contents of the first type test.

The first type test is understood as some tests performed on the semiconductor functional structure when a running speed is low.

It should be noted that in a memory, a running speed refers to the reading or writing speed of the memory.

Here, the first pad 303 can be used to contact with a probe card to realize an electrical connection between the interconnecting layer and other test systems when performing the first type test, and can also be used for leading out a bonding wire which is electrically connected to the interconnecting layer 202 by the first pad 303.

On the one hand, it is understandable that due to the limitation of a test probe card and a pad of wire bonding package, there is a minimum area requirement for windowing region (that is, the area of the first pad) in the top metal layer windowing manner. While, in the redistribution layer windowing manner, there is only a limitation of the minimum area of the region connected to the interconnecting layer.

On the other hand, considering that in the embodiment of the disclosure, both the top metal layer windowing manner and the redistribution layer windowing manner are adopted, a top metal layer and a redistribution layer respectively with a large area are inevitably required, either of which introduces additional parasitic capacitance. Exemplarily, the introduced additional parasitic capacitance is detrimental to high-speed ports of a low power double data rate (LPDDR).

Based on this, after that the test at a low speed is stable (after first type test meets a preset condition) and the process is mature, it is necessary to start to debug the performance at a high speed, and pads of the redistribution layer are needed. In this case, the large top metal layer prepared for windowing can be tailored, provided that it meets the design requirements.

After completing the first type test, the first pad can be cut to reduce its area to a minimum area as long as it satisfies the connection between the redistribution layer an the interconnecting layer.

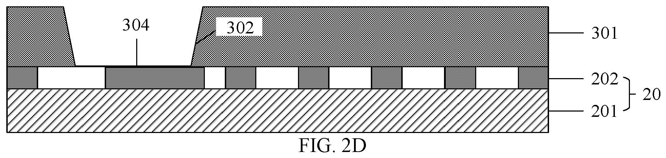

In view of this, in this Application, referring to FIG. 2D, after completing the first type test, part of the first pad 303 is removed to form a fourth pad 304. The area of the fourth pad 304 is smaller than an area of the first pad 303.

Here, the removed part of the interconnecting layer 202 is the part of the first pad 303, and the remaining part of the first pad 303 is the fourth pad 304. As can be seen from the drawings, the area of the first pad 303 is slightly greater than a cross-sectional area of the via hole 302, and the area of the fourth pad 304 is apparently less than the cross-sectional area of the via hole 302. Based on this, it can be understood that the area of fourth pad 304 is less than the cross-sectional area of the via hole 302.

It is understandable that, by reducing the area of the first pad 303, on one hand, additional parasitic capacitance caused by the first pad 303 can be reduced; on the other hand, parasitic resistance and electro-migration are reduced, thereby further meeting the production requirements.

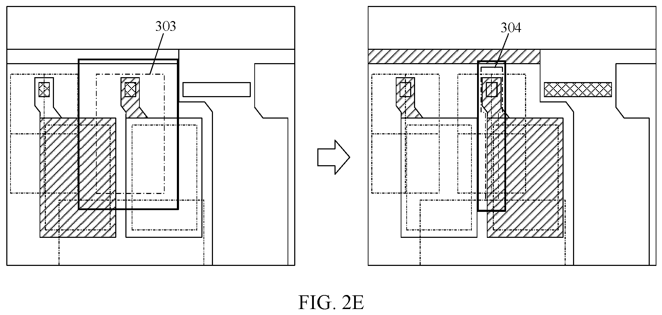

Exemplarily, referring to FIG. 2E, the area of the first pad 303 is reduced to the area of the fourth pad 304, and the parasitic capacitance of a semiconductor device is decreased by 5.3%.

It should be noted that FIG. 2E shows corresponding top views of FIG. 2C and FIG. 2D.

In an actual manufacturing process not forming part of the present invention but useful for understanding, whether to reduce the area of the first pad to the area of the fourth pad can be selected according to actual requirements. In the present invention, the area of the first pad is reduced to the area of the fourth pad.

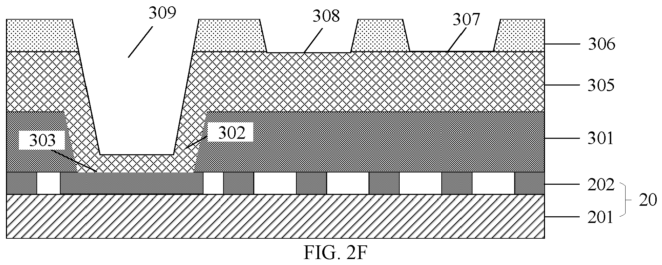

However, in order to clearly describe the disclosure, in the following part, description is made by taking the case that the first pad area is not reduced as an example. That is, in FIG. 2F to FIG. 2G, the redistribution layer is still formed on the basis of the first pad, but the description applies correspondingly to the fourth pad.

At S103, referring to FIG. 2F, after completing the first type test, a redistribution layer 305 is formed.

It should be noted that completing the first type test includes performing and passing the first type test. Passing the first type test includes that a result of the first type test meets the preset conditions. The preset conditions can be understood as the test requirements set for the semiconductor functional structure 20 according to actual requirements.

Here, after the result of the first type test meets the preset conditions, the redistribution layer 305 is formed on the first pad 303 and the isolation layer 301. The redistribution layer 305 and the interconnecting layer 202 are electrically connected.

In some embodiments, when the result of the first type test does not meet the preset conditions, the subsequent process of the packaging method provided by the embodiment of the disclosure for the further manufacture may not be carried out, and the tested semiconductor functional structure 20 is adjusted until a result of the first type test meets the preset condition, and then the subsequent process of the packaging method provided by the embodiment of the disclosure for the further manufacture is carried out.

Here, the material constituting the redistribution layer 305 includes, but is not limited to, a metal. Preferably, the material of the redistribution layer is aluminum (Al).

In some specific examples, a specific manner of forming the redistribution layer 305 includes: forming a new wire pattern on the isolation layer 301 in an exposure and development manner, and then forming the redistribution layer 305 according to the new wire pattern by an electroplating technique. The redistribution layer 305 includes new wire paths, which are electrically connected to the interconnecting layer 202.

In some specific example, forming the redistribution layer on the first pad and the isolation layer includes: forming the redistribution layer 305 on the first pad 303 and the isolation layer 301 by a maskless deposition process.

The maskless deposition process can be understood as forming the redistribution layer 305 directly on the first pad 303 and the isolation layer 301 without forming a mask.

In this way, adopting the maskless deposition process can not only save costs of a mask plate and a manufacturing equipment thereof, but also improves flexibility of the deposition process and improves the production efficiency, thereby shortening the production cycle and reducing the manufacturing costs.

At S104, referring to FIG. 2F, a first insulating layer 306 is formed on the redistribution layer 305.

The first insulating layer 306 covers the redistribution layer to protect the redistribution layer 305 from being damaged. In addition, parts of the first insulating layer 306 are removed, to expose parts of the redistribution layer 305.

The material of the first insulating layer 306 includes, but is not limited to, polyimide (PI).

Here, a process for forming the first insulating layer 306 includes, but is not limited to, a PVD process, a CVD process, an ALD process or the like. The removal process includes, but is not limited to, an etching process or the like. It should be noted that, in some example, the first insulating layer 306 not only exposes parts of the redistribution layer to form a second pad 307 and a third pad 308, but also exposes the redistribution layer 305 located on the first pad 303, such that a second insulating layer is filled in a groove formed by the redistribution layer 305 subsequently. At this time, the density of the second insulating layer may be equal to or less than the density of the first insulating layer 306. In other examples, the first insulating layer 306 also covers the bottom surface and the sidewalls of the groove formed by the redistribution layer 305, and the second insulating layer is subsequently formed in a groove formed by the first insulating layer 306.

Referring to FIG. 2F, the exposed parts of the redistribution layer include the second pad 307 and the third pad 308. The second pad 307 is used for performing a second type test, and the third pad 308 is used for executing a functional interaction corresponding to the contents of the second type test.

The second type test is understood as some tests performed on the semiconductor functional structure when the running speed is high. Executing a functional interaction corresponding to the contents of the second type test can be understood as leading out a bonding wire from the third pad.

Here, positions of the second pad 307 and the third pad 308 can be selected and disposed according to actual requirements.

That is, in some example of the disclosure, the redistribution layer 305 and the interconnecting layer 202 are electrically connected to lead out the electrical signals of the semiconductor functional structure 20. Then, windowing positions of the second pad 307 and the third pad 308 are disposed according to actual requirements. Next, the electrical test and the functional interaction thereof are performed on the semiconductor functional structure 20 by the second pad 307 and the third pad 308.

In other words, the redistribution layer 305 is used to redistribute wire paths based on the layout of the wire paths of the first pad 303. Here, the redistributed wire paths are more conducive to the electrical test and functional interaction thereof of the semiconductor device.

In some embodiments, the second pad 307 is located at a side close to an edge of the semiconductor functional structure; and the third pad 308 is located at a side away from the edge of the semiconductor functional structure.

It is understandable that, controllability or adjustability of a process for leading out the bonding wire on the pad is relatively flexible, and a process for aligning the pad with the probe card is relatively difficult. Here, when the second pad 307 is disposed at a side close to the edge of the semiconductor functional structure; it is beneficial to reducing the difficulty of aligning the pad and the probe card, thereby reserving more flexibility for the probe card during performing the test.

In other embodiments, the second pad 307 is located at a side away from the edge of the semiconductor functional structure, and the third pad 308 is located at a side close to the edge of the semiconductor functional structure.

It is understandable that, referring to FIG. 2F, when the third pad 308 is disposed at the side close to the edge of the semiconductor functional structure, it is beneficial to shorten the length of a bonding wire welded on the third pad 308, and enlarge the bonding process window.

In some example, referring to FIG. 2F, after the redistribution layer 305 is formed, the groove 309 is provided in the middle region of the redistribution layer 305 on the first pad 303.

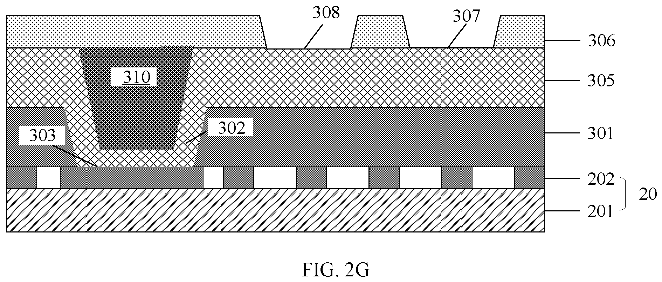

Referring to FIG. 2G, the method further includes forming a second insulating layer 310 in the groove 309 enclosed with the redistribution layer. A hardness of the material of the second insulating layer 310 is less than a hardness of the material of the redistribution layer 305.

Here, as the hardness of the material of the second insulating layer 310 is smaller, on the one hand, it is beneficial to reduce the stress of the package structure, and increase the reliability; on the other hand, compared to the case of filling the groove with the redistribution layer, filling the groove 309 with the material of the second insulating layer 310 can avoid generating greater parasitic capacitance.

Exemplarily, the material constituting the second insulating layer 310 includes, but is not limited to, polyimide (PI). A process for forming the second insulating layer 310 includes, but is not limited to, a process of PVD, CVD, ALD or the like.

In some embodiments, materials of the second insulating layer 310 and the first insulating layer 306 may be the same. Correspondingly, the second insulating layer 310 may be formed in the same operation for forming the first insulating layer 306. The second insulating layer 310 and the first insulating layer 306 are an integrated structure.

As mentioned above, the redistribution layer 305 is formed directly on the first pad 303 and the isolation layer 301 by the maskless deposition process, so that the redistribution layer 305 and the first pad 303 are electrically conductive by a physical contact manner.

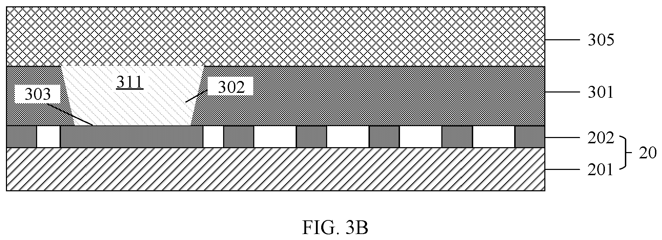

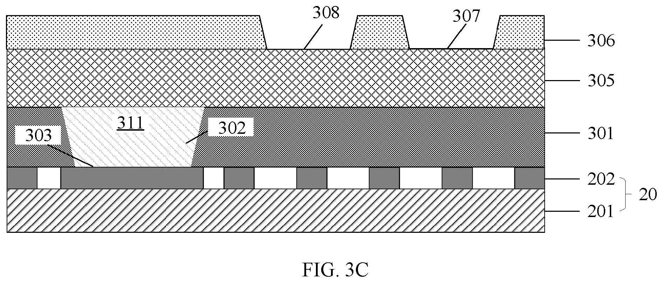

Here, another conductive manner between the redistribution layer 305 and the first pad 303 is provided, that is, the redistribution layer 305 and the first pad 303 are electrically conductive by a conductive pillar. This manner is described in detail with reference to FIG. 3A, FIG. 3B and FIG. 3C.

In some examples not forming part of the present invention but useful for understanding, referring to FIG. 3A, FIG. 3B and FIG. 3C, the method further includes the following operations.

After completing the first type test, a conductive pillar 311 is formed on the first pad 303; and forming the redistribution layer 305 on the first pad 303 and the isolation layer 301 includes: forming the redistribution layer 305 on the conductive pillar 311 and the isolation layer 301. The redistribution layer 305 and the interconnecting layer 202 are electrically connected by the conductive pillar 311.

Referring to FIG. 3A, the material of the conductive pillar 311 and the material of the redistribution layer 305 may be the same or different. It should be noted that the height of the conductive pillar 311 may be equal to or less than the depth of the via hole 302, and FIG. 3A shows the case that the height of the conductive pillar 311 is equal to the depth of the via hole 302.

Exemplarily, the material constituting the conductive pillar 311 includes Al, copper (Cu) or the like. A process for forming the conductive pillar includes, but is not limited to, a process of PVD, CVD, ALD or the like.

Referring to FIG. 3B, the redistribution layer 305 is formed on the first pad 303 and the isolation layer 301. Here, the redistribution layer 305 and the interconnecting layer 202 are electrically connected by the conductive pillar 311.

Referring to FIG. 3C, a first insulating layer 306 is formed on the redistribution layer 305, and parts of the first insulating layer 306 are removed, exposing parts of the redistribution layer 305.

Referring to FIG. 3C, the exposed parts of the redistribution layer 305 include a second pad 307 and a third pad 308. The second pad 307 is used for performing a second type test, and the third pad 308 is used for executing the functional interaction corresponding to the contents of the second type test.

Here, positions of the second pad 307 and the third pad are selected and disposed according to actual requirements.

It should be noted that the processes for forming the redistribution layer 305, the first insulating layer 306, the second pad 307 and the third pad 308 have been described above and will not be repeated here.

It should be noted that, in the embodiments, referring to FIG. 4A, when the first type test is completed, part of the first pad 303 is removed to form a fourth pad 304.

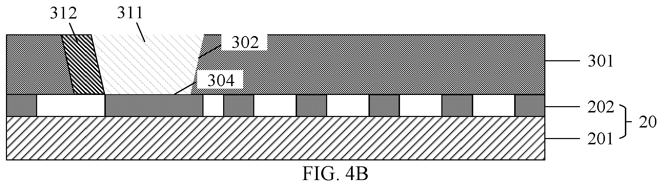

Referring to FIG. 4B, the conductive pillar 311 is formed on the surface of the fourth pad 304.

Since the area of the fourth pad 304 is less than the area of the via hole 302, actually, the conductive pillar 311 need not to fill up the via hole 302, since filing up the via hole 302 will increase additional parasitic capacitance. In actual operations of the process, the deposition process may be performed by using the mask for etching the first pad 303 to form the fourth pad 304, to form a third insulating layer 312 filling part of the via hole 302, and after the third insulating layer 312 is formed, the conductive pillar 311 is formed, filling up the via hole 302.

The material of the third insulating layer 312 includes, but is not limited to, polyimide (PI). A process for forming the third insulating layer 312 includes, but is not limited to, a process of PVD, CVD, ALD or the like.

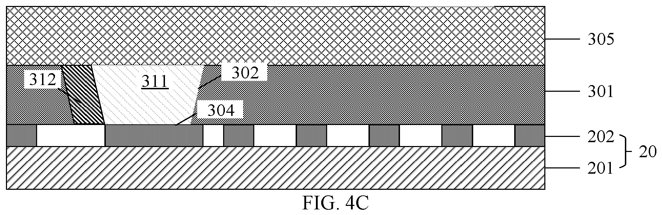

Referring to FIG. 4C, the redistribution layer 305 is formed on the conductive pillar 311 and the isolation layer 301.

In other words, the conductive pillar 311 is located between the fourth pad 304 and the redistribution layer 305, and the redistribution layer 305 and the interconnecting layer 202 are electrically connected by the conductive pillar 311.

It should be noted that FIG. 4C shows the cross-sectional diagram where the conductive pillar 311 has filled part of the via hole 302. In practical application, the conductive pillar 311 may also be disposed with other shapes or at other positions.

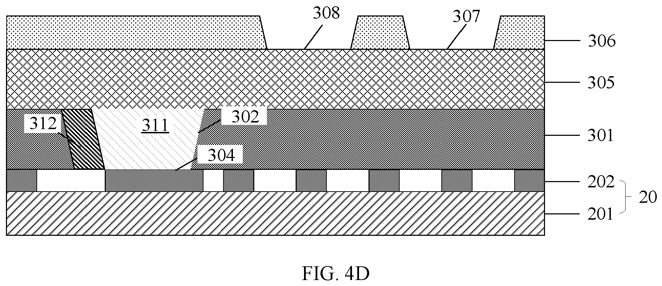

Referring to FIG. 4D, a first insulating layer 306 is formed on the redistribution layer 305, and parts of the first insulating layer 306 are removed, exposing parts of the redistribution layer 305.

The exposed parts of the redistribution layer 305 include a second pad 307 and a third pad 308. The second pad 307 is used for performing a second type test, and the third pad 308 is used for executing the functional interaction corresponding to the contents of the second type test.

Here, positions of the second pad 307 and the third pad can be selected and disposed according to actual requirements.

It should be noted that the processes for forming the fourth pad 304, the conductive pillar 311, the redistribution layer 305, the first insulating layer 306, the second pad 307 and the third pad 308 are described above and will not be repeated here.

The number of the conductive pillar 311 formed in the same via hole 302 in the above embodiment may be one or more. Accordingly, each conductive pillar 311 corresponds to a fourth pad 304, that is, when the number of conductive pillar 311 is more than one, a plurality of fourth pad 304 are provided at the bottom of the same one via hole 302.

It can be understood that when the number of conductive pillar 311 includes multiple ones, the multiple conductive pillars 311 are respectively connected to the redistribution layer 305 and the interconnecting layer 202, so that reliability of the electrical connection between the redistribution layer 305 and the interconnecting layer 202 can be increased.

In other words, in a package structure with multiple conductive pillars 311, when one conductive pillar fails to electrically connect to the redistribution layer 305 and the interconnecting layer 202, the other conductive pillars can connect the redistribution layer and the interconnecting layer, thereby improving the reliability of the electrical connection between the redistribution layer, the conductive pillars and the interconnecting layer.

Based on this, in the embodiments of the disclosure, the first pad is disposed on the semiconductor functional structure, which is used for performing the first type test when the running speed of the semiconductor functional structure is low,; after completing the first type test, removing part of the first pad to form a fourth pad, wherein an area of the fourth pad is smaller than an area of the first pad; after forming the fourth pad, the redistribution layer and the insulating layer are formed on the fourth pad to further form the second pad and the third pad, and the second pad is used for performing the second type test when the running speed of the semiconductor functional structure is high, and the third pad is used for executing the functional interaction corresponding to the contents of the second type test. In this way, the package structure compatible with the two types of tests is adopted in the disclosure, so that the semiconductor functional structure is satisfied with different types of tests in different process stages, thereby improving flexibility of testing, shortening the production cycle and reducing the manufacturing costs.

The isolation layer covers a surface of an interconnecting layer, the via hole exposes part of the interconnecting layer, and the interconnecting layer is disposed on a surface of a semiconductor functional structure.

The fourth pad consists of the interconnecting layer exposed by the isolation layer, an area of the fourth pad is less than a cross-sectional area of the via hole, and the cross-sectional area of the via hole is set according to requirements of a first type test.

The redistribution layer covers the isolation layer and is electrically connected with the fourth pad.

The first insulating layer covers and exposes parts of the redistribution layer.

The exposed parts of the redistribution layer include a second pad and a third pad. The second pad is used for performing a second type test, and the third pad is used for executing a functional interaction corresponding to contents of the second type test. A running speed of the semiconductor functional structure when performing the first type test is lower than a running speed when performing the second type test.

In some embodiments, the package structure further includes a conductive pillar.

The conductive pillar is located between the fourth pad and the redistribution layer, and the redistribution layer and the interconnecting layer are electrically connected by the conductive pillar.

In some embodiments, the number of the conductive pillar is one or more.

In some embodiments, the package structure further includes: a second insulating layer.

The second insulating layer is located in a groove surrounded the redistribution layer.

A hardness of a material of the second insulating layer is less than a hardness of a material of the redistribution layer.

In some embodiments, the second pad is located at a side close to an edge of the semiconductor functional structure; and the third pad is located at a side away from the edge of the semiconductor functional structure.

According to another aspect of the disclosure, embodiments of the disclosure further provide a semiconductor device, including: the package structure described in the foregoing embodiments of the disclosure.

In some embodiments, the semiconductor device further includes: a substrate and a plurality of bare chips.

The plurality of dies are stacked, each die includes a semiconductor functional structure and the package structure located on the semiconductor functional structure.

Each die is electrically connected to the substrate by a lead on a third pad of the package structure.

It should be noted that in the above embodiment of the disclosure, the package structure compatible with the two types of tests is adopted, so that the semiconductor functional structure can satisfied with the different types of tests in different manufacture procedure stages. However, it should be noted that in a layout design of the package structure, the position of the via hole of the redistribution layer needs to be reserved on the top metal layer to ensure that when the redistribution layer needs to be added, it is not necessary to modify the top metal layer or any photolithography plate and the process.

In addition, in the layout design, it is necessary to consider the layout of the top metal layer and its windowing (such as, the interconnecting layer and the first pad) and the layout of the redistribution layer and its windowing (the second pad and the third pad) at the same time. When a process is performed corresponding to different layout levels or photolithography plates, the two windowing regions cannot be opened at the same time.

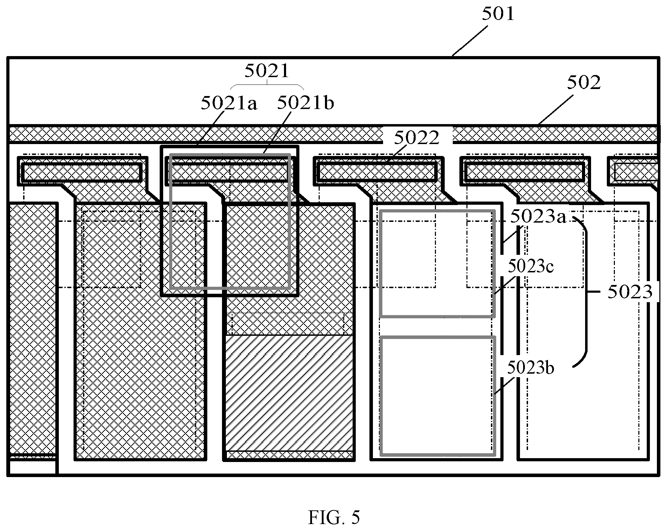

Based on this, referring to FIG. 5, according to an aspect of embodiments of the disclosure, a semiconductor device layout structure is also provided, including: a semiconductor functional structure layout layer 501 and a package structure layout layer 502 which are stacked. The package structure layout layer 502 includes a plurality of first type pad regions 5021, in which each first type pad region includes a partial interconnecting layer region 5021a and a first pad region5021b located in the partial interconnecting layer region 5021b; a plurality of conductive pillar regions 5022, in which each conductive pillar region is located on a corresponding first type pad region; and a plurality of second type pad regions 5023, in which each second type pad region is located on a corresponding conductive pillar region of the first type pad region, and includes: a redistribution layer region 5023a, and a second pad region 5023b and a third pad region 5023c located in the redistribution layer region. An orthographic projection of the first pad region on a preset plane and an orthographic projection of the redistribution layer region on the preset plane have an overlapping region, an orthographic projection of the conductive pillar region on the preset plane is located in the overlapping region, and the preset plane is perpendicular to the stacking direction.

Based on the above semiconductor device layout structure, embodiments of the disclosure also provide an application method of the semiconductor device layout structure, which includes: by utilizing the semiconductor device layout structure described in the above embodiments of the disclosure, forming a semiconductor functional structure and a plurality of first type pads, or forming a semiconductor functional structure, a plurality of first type pads, and a plurality of second type pads.

It should be noted that in a design, the layout of the top metal layer windowing (the first type pad regions) and the layout of the redistribution layer windowing (the second type pad regions) are designed at the same time, but the two windowing correspond to different layout levels or photolithography plates, that is, it is guaranteed that two windowing regions cannot be opened at the same time. That is, the semiconductor functional structure, the plurality of first type pads, the plurality of second type pads and their corresponding layout structures illustrated in the embodiments of the disclosure can be used separately.

In several embodiments provided by the disclosure, it should be understood that the disclosed devices and methods may be implemented in a non-target way. The above-described device embodiments are only schematic. For example, the division of the units is only a logical function division, and there may be other division modes in actual implementation, such as, multiple units or components may be combined or integrated into another system, or some features may be omitted or not executed. In addition, the components shown or discussed may be coupled, or directly coupled to each other.

The units described above as separate parts may or may not be physically separate, and the parts shown as a unit may or may not be a physical units, that is, they may be located in one place or distributed to multiple network units. Some or all of the units may be selected according to actual requirements to achieve the purpose of the solutions of the embodiments of the disclosure.

The features disclosed in several embodiments of the method or the device provided by the disclosure may be arbitrarily combined, as long as there is no conflict, to obtain a new embodiment of the method or a new embodiment of the device.

The above are only specific embodiments of the disclosure, and the scope of protection of the disclosure is only limited to the claims. Changes or replacements can be easily conceived of by any person skilled in the art. Therefore, the protection scope of the disclosure is defined by the protection scope of the claims.

### INDUSTRIAL PRACTICABILITY

A package structure compatible with two types of tests is adopted in the disclosure, so that a semiconductor functional structure can be subjected to different types of tests in different process stages, thereby improving flexibility of testing, shortening the production cycle and reducing the manufacturing costs.

## Claims

1. A packaging method, comprising:
providing a semiconductor functional structure (20), the semiconductor functional structure (20) comprising a semiconductor functional layer (201) and an interconnecting layer (202) being provided on a surface of the semiconductor functional layer (201);
forming an isolation layer (301) exposing part of the interconnecting layer (202), the exposed part of the interconnecting layer (202) acting as a first pad (303), and the first pad (303) being used for performing a first type test;
after completing the first type test, removing part of the first pad (303) to form a fourth pad (304), wherein an area of the fourth pad (304) is smaller than an area of the first pad (303); after forming the fourth pad (304), forming a redistribution layer (305) on the fourth pad (304) and the isolation layer (301), the redistribution layer (305) and the interconnecting layer (202) being electrically connected; and
forming a first insulating layer (306) exposing parts of the redistribution layer (305), the exposed parts of the redistribution layer (305) acting as a second pad (307) and a third pad (308), the second pad (307) being used for performing a second type test, and the third pad (308) being used for executing a functional interaction corresponding to contents of the second type test; wherein a running speed of the semiconductor functional structure (20) when performing the first type test is lower than a running speed of the semiconductor functional structure (20) when performing the second type test.

2. The packaging method according to claim 1, further comprising:
before forming the isolation layer (301), removing part of the interconnecting layer (202) to reduce an overlap area between the interconnecting layer (202) and the redistribution layer (305) to reduce an area of an electrode of the parasitic capacitance formed by the interconnecting layer (202) and the redistribution layer (305).

3. The packaging method according to claim 1, further comprising:
after completing the first type test, forming a conductive pillar (311) on the fourth pad (304),
wherein forming the redistribution layer (305) on the fourth pad (304) and the isolation layer (301) comprises:
forming the redistribution layer (305) on the conductive pillar (311) and the isolation layer (301),
wherein the redistribution layer (305) and the interconnecting layer (202) are electrically connected by the conductive pillar (311).

4. A package structure, comprising:
a semiconductor functional structure (20), the semiconductor functional structure (20) comprising a semiconductor functional layer (201) and an interconnecting layer (202) being provided on a surface of the semiconductor functional layer (201); an isolation layer (301) with a via hole (302), the isolation layer (301) covering a surface of the interconnecting layer (202), the via hole (302) exposing part of the interconnecting layer (202);
a fourth pad (304) consisting of the interconnecting layer (202) exposed by the isolation layer (301), an area of the fourth pad (304) being less than a cross-sectional area of the via hole (302), and the cross-sectional area of the via hole (302) being set based on requirements of a first type test; the fourth pad (304) is formed by removing part of the material from a first pad (303), and the first pad (303) being used for performing the first type test;
a redistribution layer (305) covering the isolation layer (301) and the fourth pad (304) and being electrically connected with the fourth pad (304); and
a first insulating layer (306) covering and exposing part of the redistribution layer (305), wherein the exposed parts of the redistribution layer (305) comprise a second pad (307) and a third pad (308), the second pad (307) is used for performing a second type test, and the third pad (308) is used for executing a functional interaction corresponding to contents of the second type test; and a running speed of the semiconductor functional structure (20) when performing the first type test is lower than a running speed of the semiconductor functional structure (20) when performing the second type test.

5. The package structure according to claim 4, further comprising:
a conductive pillar (311) located between the fourth pad (304) and the redistribution layer (305), and the redistribution layer (305) and the interconnecting layer (202) being electrically connected by the conductive pillar (311), the conductive pillar (311) together with a third insulating layer (312) fill the via hole (302).

6. The package structure according to claim 5, wherein a number of the conductive pillar (311) is one or more.

7. The package structure according to claim 5, wherein the second pad (307) is located at a side close to an edge of the semiconductor functional structure (20); and the third pad (308) is located at a side away from the edge of the semiconductor functional structure (20).

8. A semiconductor device comprising:
a substrate; and
a plurality of stacked dies, each die comprising the package structure according to any one of claims 4 to 7, wherein each die is electrically connected to the substrate by a lead on the third pad (308) of the package structure.

## Patentansprüche

1. Packagingverfahren, umfassend:
Bereitstellen einer Halbleiterfunktionsstruktur (20), wobei die Halbleiterfunktionsstruktur (20) eine Halbleiterfunktionsschicht (201) und eine auf einer Fläche der Halbleiterfunktionsschicht (201) vorgesehene Verbindungsschicht (202) umfasst;
Bilden einer Isolationsschicht (301), die einen Teil der Verbindungsschicht (202) freilegt, wobei der freigelegte Teil der Verbindungsschicht (202) als erstes Pad (303) agiert und das erste Pad (303) zum Ausführen einer ersten Typprüfung verwendet wird;
nach Abschließen der ersten Typprüfung, Entfernen eines Teils des ersten Pads (303), um ein viertes Pad (304) zu bilden, wobei eine Fläche des vierten Pads (304) kleiner ist als eine Fläche des ersten Pads (303);
nach dem Bilden des vierten Pads (304), Bilden einer Umverteilungsschicht (305) auf dem vierten Pad (304) und der Isolationsschicht (301), wobei die Umverteilungsschicht (305) und die Verbindungsschicht (202) elektrisch verbunden sind; und
Bilden einer ersten Isolierschicht (306), die Teile der Umverteilungsschicht (305) freilegt, wobei die freigelegten Teile der Umverteilungsschicht (305) als zweites Pad (307) und drittes Pad (308) agieren, das zweite Pad (307) zum Ausführen einer zweiten Typprüfung verwendet wird und das dritte Pad (308) zum Ausführen einer Funktionsinteraktion entsprechend Inhalten der zweiten Typprüfung verwendet wird;
wobei eine Laufgeschwindigkeit der Halbleiterfunktionsstruktur (20) beim Ausführen der ersten Typprüfung niedriger ist als eine Laufgeschwindigkeit der Halbleiterfunktionsstruktur (20) beim Ausführen der zweiten Typprüfung.

2. Packagingverfahren nach Anspruch 1, ferner umfassend:
vor dem Bilden der Isolationsschicht (301), Entfernen eines Teils der Verbindungsschicht (202), um einen Überlappungsbereich zwischen der Verbindungsschicht (202) und der Umverteilungsschicht (305) zu reduzieren und einen Bereich einer Elektrode der parasitären Kapazität zu reduzieren, die durch die Verbindungsschicht (202) und die Umverteilungsschicht (305) gebildet wird.

3. Packagingverfahren nach Anspruch 1, ferner umfassend:
nach Abschließen der ersten Typprüfung, Bilden einer leitfähigen Säule (311) auf dem vierten Pad (304),
wobei das Bilden der Umverteilungsschicht (305) auf dem vierten Pad (304) und der Isolationsschicht (301) umfasst:
Bilden der Umverteilungsschicht (305) auf der leitfähigen Säule (311) und der Isolationsschicht (301),
wobei die Umverteilungsschicht (305) und die Verbindungsschicht (202) durch die leitfähige Säule (311) elektrisch verbunden sind.

4. Packagestruktur, umfassend:
eine Halbleiterfunktionsstruktur (20), wobei die Halbleiterfunktionsstruktur (20) eine Halbleiterfunktionsschicht (201) und eine auf einer Fläche der Halbleiterfunktionsschicht (201) vorgesehene Verbindungsschicht (202) umfasst;
eine Isolationsschicht (301) mit einem Durchkontaktierungsloch (302), wobei die Isolationsschicht (301) eine Fläche der Verbindungsschicht (202) abdeckt und das Durchkontaktierungsloch (302) einen Teil der Verbindungsschicht (202) freilegt;
ein viertes Pad (304), das aus der durch die Isolationsschicht (301) freigelegten Verbindungsschicht (202) besteht, wobei eine Fläche des vierten Pads (304) kleiner ist als eine Querschnittsfläche des Durchkontaktierungslochs (302) und die Querschnittsfläche des Durchkontaktierungslochs (302) basierend auf Anforderungen einer ersten Typprüfung festgelegt ist; wobei das vierte Pad (304) durch Entfernen eines Teils des Materials von einem ersten Pad (303) gebildet wird und das erste Pad (303) zum Ausführen der ersten Typprüfung verwendet wird;
eine Umverteilungsschicht (305), welche die Isolationsschicht (301) und das vierte Pad (304) abdeckt und mit dem vierten Pad (304) elektrisch verbunden ist; und
eine erste Isolierschicht (306), die einen Teil der Umverteilungsschicht (305) abdeckt und freilegt,
wobei die freigelegten Teile der Umverteilungsschicht (305) ein zweites Pad (307) und ein drittes Pad (308) umfassen, das zweite Pad (307) zum Ausführen einer zweiten Typprüfung verwendet wird und das dritte Pad (308) zum Ausführen einer Funktionsinteraktion entsprechend Inhalten der zweiten Typprüfung verwendet wird; und wobei eine Laufgeschwindigkeit der Halbleiterfunktionsstruktur (20) beim Ausführen der ersten Typprüfung niedriger ist als eine Laufgeschwindigkeit der Halbleiterfunktionsstruktur (20) beim Ausführen der zweiten Typprüfung.

5. Packagestruktur nach Anspruch 4, ferner umfassend:
eine leitfähige Säule (311), die zwischen dem vierten Pad (304) und der Umverteilungsschicht (305) angeordnet ist, wobei die Umverteilungsschicht (305) und die Verbindungsschicht (202) durch die leitfähige Säule (311) elektrisch verbunden sind und die leitfähige Säule (311) zusammen mit einer dritten Isolierschicht (72) das Durchkontaktierungsloch (302) füllt.

6. Packagestruktur nach Anspruch 5, wobei eine Anzahl der leitfähigen Säulen (311) eins oder mehr beträgt.

7. Packagestruktur nach Anspruch 5, wobei das zweite Pad (307) an einer Seite nahe einer Kante der Halbleiterfunktionsstruktur (20) angeordnet ist; und das dritte Pad (308) an einer Seite entfernt von der Kante der Halbleiterfunktionsstruktur (20) angeordnet ist.

8. Halbleitervorrichtung, umfassend:
ein Substrat und
mehrere gestapelte Dies, wobei jeder Die die Packagestruktur nach einem der Ansprüche 4 bis 7 umfasst, wobei jeder Die mit dem Substrat durch eine Leitung an dem dritten Pad (308) der Packagestruktur elektrisch verbunden ist.

## Revendications

1. Procédé d'encapsulation, comprenant :
la fourniture d'une structure fonctionnelle semi-conductrice (20), la structure fonctionnelle semi-conductrice (20) comprenant une couche fonctionnelle semi-conductrice (201) et une couche d'interconnexion (202) étant prévue sur une surface de la couche fonctionnelle semi-conductrice (201) ;
la formation d'une couche d'isolation (301) exposant une partie de la couche d'interconnexion (202), la partie exposée de la couche d'interconnexion (202) agissant comme une première plage (303), et la première plage (303) étant utilisée pour réaliser un premier essai de type ;
après l'achèvement du premier essai de type, le retrait d'une partie de la première plage (303) pour former une quatrième plage (304), dans lequel une aire de la quatrième plage (304) est inférieure à une aire de la première plage (303) ;
après la formation de la quatrième plage (304), la formation d'une couche de redistribution (305) sur la quatrième plage (304) et la couche d'isolation (301), la couche de redistribution (305) et la couche d'interconnexion (202) étant électriquement connectées ; et
la formation d'une première couche isolante (306) exposant des parties de la couche de redistribution (305), les parties exposées de la couche de redistribution (305) agissant comme une deuxième plage (307) et une troisième plage (308), la deuxième plage (307) étant utilisée pour réaliser un deuxième essai de type, et la troisième plage (308) étant utilisée pour exécuter une interaction fonctionnelle correspondant à des contenus du deuxième essai de type ;
dans lequel une vitesse de déplacement de la structure fonctionnelle semi-conductrice (20) lors de la réalisation du premier essai de type est inférieure à une vitesse de déplacement de la structure fonctionnelle semi-conductrice (20) lors de la réalisation du deuxième essai de type.

2. Procédé d'encapsulation selon la revendication 1, comprenant en outre :
avant la formation de la couche d'isolation (301), le retrait d'une partie de la couche d'interconnexion (202) pour réduire une aire de chevauchement entre la couche d'interconnexion (202) et la couche de redistribution (305) pour réduire une aire d'une électrode de la capacité parasite formée par la couche d'interconnexion (202) et la couche de redistribution (305).

3. Procédé d'encapsulation selon la revendication 1, comprenant en outre :
après l'achèvement du premier essai de type, la formation d'un pilier conducteur (311) sur la quatrième plage (300),
dans lequel la formation de la couche de redistribution (305) sur la quatrième plage (304) et la couche d'isolation (301) comprend :
la formation de la couche de redistribution (305) sur le pilier conducteur (311) et la couche d'isolation (301),
dans lequel la couche de redistribution (305) et la couche d'interconnexion (202) sont électriquement connectées par le pilier conducteur (311).

4. Structure d'encapsulation, comprenant :
une structure fonctionnelle semi-conductrice (20), la structure fonctionnelle semi-conductrice (20) comprenant une couche fonctionnelle semi-conductrice (201) et une couche d'interconnexion (202) étant prévue sur une surface de la couche fonctionnelle semi-conductrice (201) ;
une couche d'isolation (301) avec un trou d'interconnexion (302), la couche d'isolation (301) recouvrant une surface de la couche d'interconnexion (202), le trou d'interconnexion (302) exposant une partie de la couche d'interconnexion (202) ;
une quatrième plage (304) constituée de la couche d'interconnexion (202) exposée par la couche d'isolation (301), une aire de la quatrième plage (304) étant inférieure à une aire en coupe transversale du trou d'interconnexion (302), et l'aire en coupe transversale du trou d'interconnexion (302) étant définie sur la base d'exigences d'un premier essai de type ; la quatrième plage (304) est formée par le retrait d'une partie du matériau d'une première plage (303), et la première plage (303) étant utilisée pour réaliser le premier essai de type ;
une couche de redistribution (305) recouvrant la couche d'isolation (301) et la quatrième plage (304) et étant électriquement connectée à la quatrième plage (304) ; et
une première couche isolante (306) recouvrant et exposant des parties de la couche de redistribution (305),
dans laquelle les parties exposées de la couche de redistribution (305) comprennent une deuxième plage (307) et une troisième plage (308), la deuxième plage (307) est utilisée pour réaliser un deuxième essai de type, et la troisième plage (308) est utilisée pour exécuter une interaction fonctionnelle correspondant à des contenus du deuxième essai de type ; et une vitesse de déplacement de la structure fonctionnelle semi-conductrice (20) lors de la réalisation du premier essai de type est inférieure à une vitesse de déplacement de la structure fonctionnelle semi-conductrice (20) lors de la réalisation du deuxième essai de type.

5. Structure d'encapsulation selon la revendication 4, comprenant en outre :
un pilier conducteur (311) situé entre la quatrième plage (304) et la couche de redistribution (305), la couche de redistribution (305) et la couche d'interconnexion (202) étant électriquement connectées par le pilier conducteur (311), le pilier conducteur (311) avec une troisième couche isolante (72) remplissant le trou d'interconnexion (302).

6. Structure d'encapsulation selon la revendication 5, dans laquelle un nombre des piliers conducteurs (311) est supérieur ou égal à un.

7. Structure d'encapsulation selon la revendication 5, dans laquelle la deuxième plage (307) est située au niveau d'un côté proche d'un bord de la structure fonctionnelle semi-conductrice (20) ; et la troisième plage (308) est située au niveau d'un côté éloigné du bord de la structure fonctionnelle semi-conductrice (20).

8. Dispositif semi-conducteur comprenant :
un substrat ; et
une pluralité de puces empilées, chaque puce comprenant la structure d'encapsulation selon l'une quelconque des revendications 4 à 7, dans lequel chaque puce est électriquement connectée au substrat par un fil conducteur sur la troisième plage (308) de la structure d'encapsulation.
